# EUROPEAN PATENT APPLICATION

(11) **EP 4 503 261 A1**
(43) Date of publication of application: **05.02.2025**
(21) Application number: 23866825.5
(22) Date of filing: 09.03.2023
(51) Int. Cl.: H01M 10/48, H01M 50/569

(54) **BATTERY CELL, BATTERY, AND ELECTRICAL APPARATUS**

(30) Priority: 21.09.2022 CN 202222499524 U
(71) Applicant: Contemporary Amperex Technology Co., Limited, Ningde City, Fujian PRC 352100 (CN)
(72) Inventor: KANG, Hairong, Ningde, Fujian 352100 (CN); HE, Jia, Ningde, Fujian 352100 (CN); ZHENG, Chenling, Ningde, Fujian 352100 (CN); WANG, Chong, Ningde, Fujian 352100 (CN); ZHOU, Fangjie, Ningde, Fujian 352100 (CN)
(74) Representative: Thoma, Michael
(86) International application number: PCT/CN2023/080550
(87) International publication number: WO 2024/060522

(57) **Abstract**

This application relates to a battery cell, a battery, and an electric apparatus. A sampling module is connected to a housing and electrically connected to a conductor. At least one conductor is disposed on the housing and electrically connected to an electrode terminal. Therefore, when status signals from the battery cell are collected, signals from at least one collection point of the sampling module are directly transmitted by the electrode terminal. **In** this way, in this application, the sampling module is integrated on the end cover and at least one conductor is electrically connected to the electrode terminal, which changes the conventional method of transmitting signals to CMC through a flexible circuit board and wiring harness, avoids the transmission of status signals from being affected by factors such as interference coupling and wiring short-circuiting, shortens the signal transmission path, and improves the reliability of signal collection by the sampling module. Moreover, in the process of signal collection, there is no need to additionally configure a flexible circuit board and wiring harness, which greatly reduces the cost of signal collection.

## Description

### CROSS-REFERENCE TO RELATED APPLICATIONS

This application claims priority to Chinese Patent Application No. 202222499524.2, filed on September 21, 2022 and entitled "BATTERY CELL, BATTERY, AND ELECTRIC APPARATUS", which is incorporated herein by reference in its entirety.

### TECHNICAL FIELD

This application relates to the field of battery technologies, and in particular to a battery cell, a battery, and an electric apparatus.

### BACKGROUND

To monitor the operating state of a battery, a battery management system (BATTERY MANAGEMENT SYSTEM, BMS for short) is usually provided. In a conventional monitoring process, status signals (such as voltage signals and temperature signals) of a battery cell are transmitted to CMC (Cell Monitoring Circuit, cell monitoring circuit in English) for collection through a flexible circuit board and wiring harness, and the collected signals are transmitted to BMU (Battery Management Unit, battery management unit in English).

However, in this monitoring method, the reliability of signal collection is affected by the flexible circuit board and wiring harness; and additional costs of arranging the flexible circuit board and wiring harness also increase.

### SUMMARY

Based on this, it is necessary to provide a battery cell, a battery, and an electric apparatus, so as to improve the reliability of signal collection and reduce the cost of signal collection.

According to a first aspect, this application provides a battery cell including: a housing; an electrode terminal; at least one conductor, disposed on the housing and electrically connected to the electrode terminal; and a sampling module, connected to the housing and electrically connected to the conductor.

In the battery cell, the sampling module is connected to the housing and electrically connected to the conductor. The conductor is disposed on the housing and electrically connected to the corresponding electrode terminal. Therefore, when status signals from the battery cell are collected, signals from at least one collection point of the sampling module are directly transmitted by the electrode terminal. In this way, in this application, the sampling module is integrated on the housing, and at least one conductor is electrically connected to the electrode terminal, which changes the conventional method of transmitting signals to CMC through a flexible circuit board and wiring harness, avoids the transmission of status signals from being affected by factors such as interference coupling and wiring short-circuiting, shortens the signal transmission path, and improves the reliability of signal collection by the sampling module. Moreover, during signal collection, there is no need to additionally configure a flexible circuit and wiring harness, which greatly reduces the cost of signal collection.

In some embodiments, the sampling module has at least one conductive portion, and when the sampling module is connected to the housing, the conductive portion is electrically connected to the conductor. In this way, during assembly, electrical conduction between the sampling module and the conductor can be achieved by simply connecting the conductive portion to the conductor, which helps to improve assembly efficiency.

In some embodiments, the housing is provided with a connecting member, the connecting member is electrically connected to the conductor, and when the sampling module is connected to the housing, the conductive portion is electrically connected to the connecting member. In this way, the corresponding connecting member is provided on the housing, so that during assembly, the electrical conduction between the sampling module and the conductor can be achieved by simply connecting the conductive portion to the connecting member.

In some embodiments, the housing has a mounting region, the connecting member is located in the mounting region, and the sampling module is mounted in the mounting region. In this way, the mounting region is provided on the housing, so that the mounting position of the sampling module is defined, thereby maintaining the consistency of the position of the sampling module in the battery cell.

In some embodiments, the sampling module is detachably mounted in the mounting region. In this way, the sampling module designed to be detachably mounted in the mounting region, so that the sampling module can be replaced, facilitating the maintenance of the battery cell.

In some embodiments, the battery cell further includes a limiting structure disposed on the housing, where the limiting structure is constructed to limit the sampling module within the mounting region and to crimp the conductive portion onto the connecting member accordingly. In this way, the limiting structure is provided, so that the sampling module is stably fixed in the mounting region, which helps to improve the reliability of signal collection. In addition, the limiting structure is used to directly crimp the conductive portion onto the connecting member, which not only helps to improve the electrical connection strength but also facilitates the electrical connection between the conductive portion and the connecting member, improving assembly efficiency.

In some embodiments, the limiting structure includes a first limiting piece, where the first limiting piece and the connecting member are spaced apart within the mounting region along a preset direction, the preset direction is perpendicular to a thickness direction of the housing in the mounting region, the first limiting piece limits one end of the sampling module in the preset direction, and the second limiting piece limits a side face of the sampling module facing away from the mounting region. In this way, the first limiting piece is used, so that the sampling module is effectively limited in at least one direction, ensuring stable crimping of the conductive portion and the connecting member, thereby improving the reliability of collection.

In some embodiments, the limiting structure further includes a second limiting piece, where the second limiting piece limits a side face of the sampling module facing away from the mounting region. In this way, the first limiting piece and the second limiting piece are used, so that the sampling module is effectively limited in at least two directions, ensuring stable crimping of the conductive portion and the connecting member, thereby improving the reliability of collection.

In some embodiments, at least one of the first limiting piece and the second limiting piece moves or deforms to allow the sampling module to be limited or released within the mounting region. In this way, the sampling module can be limited or released by deforming or moving at least one of the first limiting piece and the second limiting piece, facilitating the mounting and removal of the sampling module.

In some embodiments, the mounting region is provided with a first concave portion, the first limiting piece is disposed on an inner wall of the first concave portion and at least partially protrudes from the first concave portion, and the first limiting piece is constructed to be elastically pressed into the first concave portion. In this way, the first limiting piece is designed to be elastically pressed into the first concave portion, so that the sampling module can be more conveniently mounted into the mounting region, improving assembly efficiency. In addition, the first limiting piece at least partially protrudes from the first concave portion, so that the sampling module mounted in the mounting region can abut against the first limiting piece, ensuring stable fixation of the sampling module.

In some embodiments, in the thickness direction of the housing in the mounting region, there is a mounting gap between the second limiting piece and the mounting region. The mounting gap is constructed to allow the sampling module squeezing the first limiting piece to move along the preset direction, and when the sampling module moves to a point where the conductive portion is crimped onto the connecting member, the first limiting piece springs up and limits one end of the sampling module. In this way, the mounting gap is provided between the second limiting piece and the mounting region, so that during the mounting of the sampling module, the sampling module can be limited and electrically connected by simply moving in the mounting gap along the preset direction, making the mounting of the sampling module more convenient.

In some embodiments, the sampling module is provided with a notch, where the notch is configured for the sampling module to pass through the second limiting piece. In this way, the notch is used to avoid interference from the second limiting piece, ensuring the smooth placement of the sampling module into the mounting region, thereby better completing the assembly of the sampling module.

In some embodiments, the connecting member includes a connecting piece electrically connected to the conductor, the mounting region is provided with a second concave portion spaced apart from the first concave portion along the preset direction, and the connecting piece is elastically disposed on an inner wall of the second concave portion and at least partially protrudes from the second concave portion. In this way, the connecting piece is elastically disposed on the inner wall of the second concave portion and at least partially protrudes from the second concave portion, which ensures stable contact between the connecting piece and the conductive portion, and avoids structural damage caused by rigid contact therebetween.

In some embodiments, in the same connecting member, the connecting piece is provided in at least two, and all the connecting pieces are spaced apart on the inner wall of the second concave portion and electrically connected to the same conductor. In this way, a plurality of connecting pieces are arranged in the second concave portion, so that the number of contact points between the connecting member and the conductive portion is increased, which helps to ensure stable electrical conduction therebetween.

In some embodiments, the limiting structure further includes a third limiting piece, where the third limiting piece is located at an end of the mounting region close to the connecting member, and a limiting gap is left between the third limiting piece and the mounting region. In this way, the limiting gap is left between the third limiting piece and the mounting region. When the sampling module moves along the preset direction, one end of the sampling module is inserted into the limiting gap, which avoids one end of the sampling module being lifted up due to contact between the conductive portion and the connecting member, thereby ensuring the stable fixation of the sampling module in the mounting region.

In some embodiments, the connecting member is electrically plugged in the corresponding conductive portion. With such a design, the connecting member is electrically plugged in the conductive portion, which not only ensures stable electrical connection between the connecting member and the conductive portion, but also implements detachable connection between the sampling module and the mounting region depending on their electrical plugging, facilitating assembly and maintenance.

In some embodiments, the conductive portion includes a plug-in protrusion protruding from a surface of the sampling module, where the plug-in protrusion is plug-fitted with the connecting member. In this way, the plugging method is used, so that the sampling module is quickly electrically connected to the connecting member, improving assembly efficiency.

In some embodiments, the connecting member includes a first clamping piece and second clamping piece disposed in the mounting region, where the first clamping piece and the second clamping piece are configured for the plug-in protrusion to be plugged in. In this way, the connecting member is designed as the first clamping piece and the second clamping piece, so that the conductive portion can be stably plugged in the connecting member, which ensures good electrical contact and helps to improve the reliability of signal collection.

In some embodiments, the connecting member includes a conductive elastic piece disposed in the mounting region, a plug-in hole extending along the thickness direction of the housing in the mounting region is formed in the mounting region, the plug-in protrusion is plug-fitted with the plug-in hole, the conductive elastic piece is disposed on a side wall of the plug-in hole and abuts against the plug-in protrusion under the elastic force of the conductive elastic piece, and the conductor is electrically connected to the plug-in protrusion through the conductive elastic piece. The plug-in protrusion is plug-fitted with the plug-in hole, and under the elastic force of the conductive elastic piece, the plug-in protrusion always maintains electrical connection with the conductive elastic piece, which has good electrical contact, so as to improve the reliability of signal collection by the sampling module.

In some embodiments, the battery cell further includes a fastener, the sampling module is provided with a through hole extending along the thickness direction of the housing, and the fastener passes through the through hole to be connected to the mounting region of the housing. The sampling module and the housing can be disassembled and assembled through the fastener, which provides a simple structure and makes assembly and disassembly convenient.

In some embodiments, the electrode terminal, the plug-in protrusion, the conductor, and plug-in hole are all provided in two, where the two plug-in protrusions and the two plug-in holes are both spaced apart along a preset direction, the preset direction is perpendicular to the thickness direction of the housing in the mounting region, one electrode terminal is electrically connected to one conductive elastic piece through one conductor, one conductive elastic piece is electrically connected to one plug-in protrusion, the other electrode terminal is electrically connected to the other conductive elastic piece through the other conductor, and the other conductive elastic piece is electrically connected to the other plug-in protrusion.

In this way, the electrical connection between the two electrode terminals of the battery cell and the two plug-in protrusions of the sampling module can be achieved, and the reliability of the electrical connection between the electrode terminals and the sampling module can be improved through such arrangement of the conductive elastic pieces.

In some embodiments, the number of conductive elastic pieces in the plug-in hole is two, and the two conductive elastic pieces are located on opposite sides of the plug-in protrusion.

In this way, the reliability of the electrical connection between the conductive elastic pieces and the plug-in protrusion can be further improved.

In some embodiments, the housing is provided with a mounting groove, where the mounting region is a bottom wall of the mounting groove. In this way, the mounting region is constructed as the bottom wall of the mounting groove, so that the mounting region have a certain height difference from the surface of the housing, which makes the mounting of the sampling module more stable and also avoids the sampling module protruding from the surface of the housing, leading to the ineffective utilization of the space in a height direction of the battery cell.

In some embodiments, the housing includes a shell and an end cover covering the shell, where the sampling module, the electrode terminal, and the conductor are all connected to the end cover. In this way, the sampling module and the conductor are both arranged on the end cover, so that the conductor is more easily electrically connected to the electrode terminal on the end cover, which shortens the transmission path of the electrical signal and helps to improve the reliability of signal collection by the sampling module.

In some embodiments, the end cover is provided with a through hole extending along a thickness direction of the end cover, where the through hole is configured for the mounting of the electrode terminal, and one end of the conductor disposed on the end cover extends into the through hole. In this way, one end of the conductor extends into the through hole, which makes the electrical connection between the electrode terminal and the conductor more convenient and helps to improve the assembly efficiency of the battery cell.

In some embodiments, the conductor is embedded in the end cover, and one end of the conductor extends and passes through a wall of the through hole. In this way, embedding the conductor in the end cover avoids the conductor from being directly exposed on the surface of the end cover, which can easily cause structural interference inside the battery cell; and in addition, embedding the conductor in the end cover can also implement the insulation of the outer surface of the conductor.

In some embodiments, the numbers of through holes and conductors are both two, the two conductors are both disposed on the end cover, and one ends of the two conductors respectively extend into the two through holes. In this way, one ends of the conductors extend into the corresponding through holes, so that the conductors can be electrically connected to the electrode terminals and transmit status signals through the electrode terminals, which further improves the reliability of signal collection.

According to a second aspect, this application provides a battery, including the foregoing battery cell.

According to a third aspect, this application provides an electric apparatus, including the foregoing battery, where the battery is configured to provide electric energy.

The foregoing description is merely an overview of the technical solution of this application. For a better understanding of the technical means in this application such that they can be implemented according to the content of the specification, and to make the above and other objectives, features, and advantages of this application more obvious and easier to understand, the following describes specific embodiments of this application.

### BRIEF DESCRIPTION OF DRAWINGS

Persons of ordinary skill in the art can clearly understand various other advantages and benefits by reading the detailed description of the preferred embodiments below. The accompanying drawings are merely intended to illustrate the preferred embodiments and are not intended to limit this application. In addition, in all the accompanying drawings, same parts are denoted by same reference signs. In the accompanying drawings:
FIG. 1 is a schematic structural diagram of a vehicle according to some embodiments of this application;
FIG. 2 is an exploded view of a battery according to some embodiments of this application;
FIG. 3 is a schematic structural exploded view of a battery cell according to some embodiments of this application;
FIG. 4 is a schematic structural diagram of assembly on an end cover according to some embodiments of this application;
FIG. 5 is a schematic structural diagram of a sampling module in FIG. 4;
FIG. 6 is an enlarged schematic diagram of a structure of circle A in FIG. 4.
FIG. 7 is a schematic structural diagram of assembly on an end cover according to some other embodiments of this application;
FIG. 8 is a schematic structural diagram of the end cover in FIG. 7;
FIG. 9 is an enlarged schematic diagram of a structure of circle B in FIG. 8;
FIG. 10 is a schematic structural diagram of a sampling module in FIG. 7;
FIG. 11 is a cross-sectional view of assembly on the end cover in FIG. 4;
FIG. 12 is a schematic structural diagram of assembly on an end cover according to some other embodiments of this application;
FIG. 13 is a top view of assembly on an end cover according to some other embodiments of this application;
FIG. 14 is a partially enlarged view of circle C in FIG. 13; and
FIG. 15 is an axonometric view of connection between a sampling module and a fastener in FIG. 12.

1000: vehicle; 100: battery; 200: controller; 300: motor; 110: battery cell; 120: box; 121: first portion; 122: second portion; 10: housing; 11: end cover; 11a: mounting region; 11b: mounting groove; 11c: groove; 11d: through hole; 11e: first concave portion; 11f: second concave portion; 11g: plug-in hole; 111g: first plug-in hole; 112g: second plug-in hole; 12: sampling module; 12a: conductive portion; 12b: plug-in protrusion; 12c: notch; 13: conductor; 14: limiting structure; 14a: first limiting piece; 14b: second limiting piece; 14c: third limiting piece; 14d: mounting gap; 14e: limiting gap; 15: connecting member; 15a: connecting piece; 15b: first clamping piece; 15c: second clamping piece; 15d: conductive elastic piece; 20: shell; 30: electrode assembly; 40: electrode terminal; X: preset direction; Y: thickness direction of housing in the mounting region; and 50: fastener.

### DESCRIPTION OF EMBODIMENTS

The following describes in detail the embodiments of technical solutions of this application with reference to the accompanying drawings. The following embodiments are merely intended for a clearer description of the technical solutions of this application and therefore are used as just examples which do not constitute any limitations on the protection scope of this application.

Unless otherwise defined, all technical and scientific terms used herein shall have the same meanings as commonly understood by those skilled in the art to which this application relates. The terms used herein are intended to merely describe the specific embodiments rather than to limit this application. The terms "include", "comprise", and "have" and any other variations thereof in the specification, claims, and brief description of drawings of this application are intended to cover non-exclusive inclusions.

In the description of the embodiments of this application, the terms "first", "second" and the like are merely intended to distinguish between different objects, and shall not be understood as any indication or implication of relative importance or any implicit indication of the number, specific sequence, or primary-secondary relationship of the technical features indicated. In the description of the embodiments of this application, "a plurality of" means at least two unless otherwise specifically stated.

In this specification, reference to "embodiment" means that specific features, structures or characteristics described with reference to the embodiment may be incorporated in at least one embodiment of this application. The word "embodiment" appearing in various places in this specification does not necessarily refer to the same embodiment or an independent or alternative embodiment that is exclusive of other embodiments. Persons skilled in the art explicitly and implicitly understand that the embodiments described herein may be combined with other embodiments.

In the description of some embodiments of this application, the term "and/or" is only an associative relationship for describing associated objects, indicating that three relationships may be present. For example, A and/or B may indicate the following three cases: presence of only A, presence of both A and B, and presence of only B. In addition, a character "/" in this specification generally indicates an "or" relationship between contextually associated objects.

In the descriptions of the embodiments of this application, the term "a plurality of" means more than two (inclusive). Similarly, "a plurality of groups" means more than two (inclusive) groups, and "a plurality of pieces" means more than two (inclusive) pieces.

In the description of the embodiments of this application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", "circumferential", and the like are based on the orientations or positional relationships as shown in the accompanying drawings. These terms are merely for ease and brevity of description of the embodiments of this application rather than indicating or implying that the means or components mentioned must have specific orientations or must be constructed or manipulated according to specific orientations, and therefore shall not be construed as any limitations on the embodiments of this application.

In the description of the embodiments of this application, unless otherwise specified and defined explicitly, the technical terms "mounting", "connection", "joining", and "fastening" should be understood in their general senses. For example, they may refer to a fixed connection, a detachable connection, or an integrated connection, may refer to a mechanical connection or an electrical connection, and may refer to a direct connection, an indirect connection through an intermediate medium, an internal connection between two elements, or an interaction between two elements. Persons of ordinary skill in the art can understand specific meanings of these terms in this application as appropriate to specific situations.

Currently, from a perspective of the market development, application of traction batteries is being more extensive. Traction batteries have been not only used in energy storage power supply systems such as hydroelectric power plants, thermal power plants, wind power plants, and solar power plants, but also widely used in many other fields including electric transportation tools such as electric bicycles, electric motorcycles, and electric vehicles, military equipment, and aerospace. With the continuous expansion of application fields of traction batteries, market demands for traction batteries are also increasing.

To monitor the operating state of the battery, a battery management system (BATTERY MANAGEMENT SYSTEM, BMS for short) is usually provided. A conventional battery management system includes a BMU (Battery Management Unit, battery management unit in English) and a CMC (Cell Monitoring Circuit, cell monitoring circuit in English). During the monitoring, because the conventional sampling module is integrated with the CMC, when status signals of the battery cell are collected, it is necessary to additionally transmit the status signals (such as voltage signals and temperature signals) of the battery cell to the CMC for collection through a flexible circuit board and wiring harness, and the collected signals are then transmitted to the BMU.

The CMC integrated with the sampling module relies on the flexible circuit board and wiring harness to collect signals from the battery cell, and the collected signals are easily affected by the flexible circuit board and wiring harness, for example, interference coupling and wiring harness short-circuiting, resulting in reduced reliability of the signals collection. Moreover, using the flexible circuit board and wiring harness to transmit signals requires additional arrangement of the flexible circuit board and wiring harness, resulting in increased cost of signal collection.

Based on this, to solve the problems of reduced reliability of signal collection and increased cost of collection caused by the conventional method of transmitting signals using the flexible circuit board and wiring harness, this application provides a battery cell. A sampling module is connected to a housing and collects the status signals of the battery cell using a conductor. The conductor is disposed on an end cover and configured to be electrically connected to an electrode terminal.

The sampling module is connected to the housing and electrically connected to the conductor. At least one conductor is disposed on the housing and electrically connected to the electrode terminal. Therefore, when status signals from the battery cell are collected, signals from at least one collection point of the sampling module are directly transmitted by the electrode terminal. In this way, in this application, the sampling module is integrated on the housing, and at least one conductor is electrically connected to the electrode terminal, which changes the conventional method of transmitting signals to CMC through a flexible circuit board and wiring harness, avoids the transmission of status signals from being affected by factors such as interference coupling and wiring short-circuiting, shortens the signal transmission path, and improves the reliability of signal collection by the sampling module. Moreover, during signal collection, there is no need to additionally configure a flexible circuit and wiring harness, which greatly reduces the cost of signal collection.

The battery cell disclosed in the embodiments of this application may be used without limitation in an electric apparatus such as a vehicle, a ship, or an aircraft. The battery cell, battery, and the like disclosed in this application may be used to constitute a power supply system of that electric apparatus.

An embodiment of this application provides an electric apparatus that uses a battery as a power source. The electric apparatus may be but is not limited to a mobile phone, a tablet, a laptop computer, an electric toy, an electric tool, an electric bicycle, an electric car, a ship, or a spacecraft. The electric toy may be a fixed or mobile electric toy, for example, a game console, an electric toy car, an electric toy ship, and an electric toy airplane. The spacecraft may include an airplane, a rocket, a space shuttle, a spaceship, and the like.

For ease of description, an electric apparatus according to an embodiment of this application being a vehicle 1000 is used as an example for description of the following embodiments.

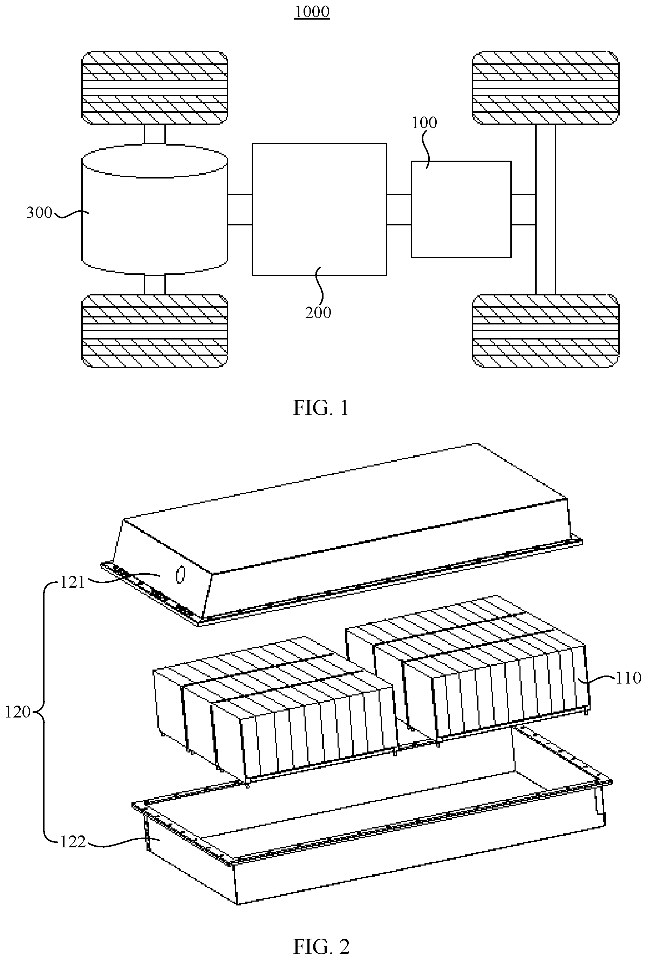

Refer to FIG. 1. FIG. 1 is a schematic structural diagram of a vehicle 1000 according to some embodiments of this application. The vehicle 1000 may be a fossil fuel vehicle, a natural-gas vehicle, or a new energy vehicle, where the new energy vehicle may be a battery electric vehicle, a hybrid electric vehicle, a range-extended vehicle, or the like. The vehicle 1000 is provided with a battery 100 inside, where the battery 100 may be arranged at the bottom, front, or rear of the vehicle 1000. The battery 100 may be configured to supply power to the vehicle 1000. For example, the battery 100 may be used as an operational power supply for the vehicle 1000. The vehicle 1000 may further include a controller 200 and a motor 300, where the controller 200 is configured to control the battery 100 to supply power to the motor 300, for example, to satisfy power needs of start, navigation, and driving of the vehicle 1000.

In some embodiments of this application, the battery 100 can be used as not only the operational power source for the vehicle 1000 but also a driving power source for the vehicle 1000, replacing or partially replacing fossil fuel or natural gas to provide driving traction for the vehicle 1000.

Refer to FIG. 2. FIG. 2 is an exploded view of a battery 100 according to some embodiments of this application. The battery 100 includes a box 120 and a battery cell 110, where the battery cell 110 is accommodated in the box 120. The box 120 is configured to provide an accommodating space for the battery cell 110. The box 120 may be a variety of structures. In some embodiments, the box 120 may include a first portion 121 and a second portion 122. The first portion 121 and the second portion 122 fit with each other so that the first portion 121 and the second portion 122 jointly define an accommodating space for accommodating the battery cell 110. The second portion 122 may be a hollow structure with an opening at one end, the first portion 121 may be a plate structure, and the first portion 121 is engaged with the opening side of the second portion 122, so that the first portion 121 and the second portion 122 jointly define the accommodating space; or the first portion 121 and the second portion 122 may both be hollow structures with an opening on one side, and the opening side of the first portion 121 is engaged with the opening side of the second portion 122. Certainly, the box 120 formed by the first portion 121 and the second portion 122 may be in various shapes, for example, cylinder or cuboid.

In the battery 100, the battery cell 110 may be provided in plurality, and the plurality of battery cells 110 may be connected in series, parallel, or series-parallel, where being connected in series-parallel means a combination of series and parallel connections of the plurality of battery cells 110. The plurality of battery cells 110 may be directly connected in series, parallel, or series-parallel, and an entirety constituted by the plurality of battery cells 110 is accommodated in the box 120. Certainly, the battery 100 may alternatively be formed by connecting a plurality of battery cells 110 in series, parallel, or series-parallel first to constitute a battery 100 module, then connecting a plurality of battery 100 modules in series, parallel, or series-parallel to constitute an entirety, and accommodating the entirety in the box 120. The battery 100 may further include other structures. For example, the battery 100 may further include a busbar configured to implement electrical connection between the plurality of battery cells 110.

Each battery cell 110 may be a secondary battery or a primary battery, or may be a lithium-sulfur battery 100, a sodium-ion battery, or a magnesium-ion battery, but is not limited thereto. The battery cell 110 may be cylindrical, flat, cuboid, or in other shapes.

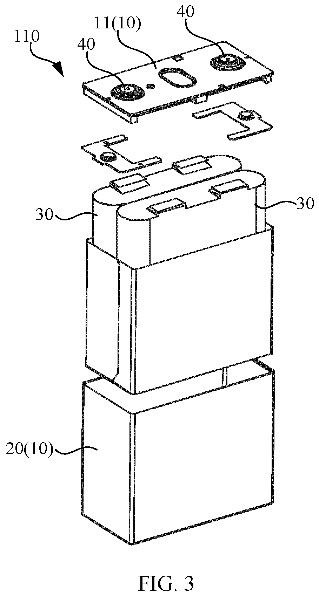

Refer to FIG. 3. FIG. 3 is a schematic structural exploded view of a battery cell 110 according to some embodiments of this application. The battery cell 110 refers to a smallest element constituting the battery 100. As shown in FIG. 3, the battery cell 110 includes an end cover 11, a shell 20, an electrode assembly 30, and other functional components.

The end cover 11 refers to a component that covers an opening of the shell 20 to separate an internal environment of the battery cell 110 from an external environment. Without limitation, a shape of the end cover 11 may be adapted to a shape of the shell 20 so that the end cover 11 fits with the shell 20. Optionally, the end cover 11 may be made of a material with certain hardness and strength (for example, aluminum alloy), so that the end cover 11 is less likely to deform when subjected to squeezing or collision, allowing the battery cell 110 to have higher structural strength and enhanced safety performance. The end cover 11 may be provided with functional components such as an electrode terminal. The electrode terminal may be configured to be electrically connected to the electrode assembly 30 for outputting or inputting electrical energy of the battery cell 110. In some embodiments, the end cover 11 may further be provided with a pressure relief mechanism for releasing internal pressure when the internal pressure or a temperature of the battery cell 110 reaches a threshold. The end cover 11 may also be made of various materials, such as copper, iron, aluminum, stainless steel, aluminum alloy, and plastic, which are not particularly limited in the embodiments of this application. In some embodiments, an insulator may also be provided on an inner side of the end cover 11. The insulator may be configured to separate an electrically connected component in the shell 20 from the end cover 11 so as to reduce the risk of short circuit. For example, the insulator may be made of plastic, rubber, or the like.

The shell 20 is an assembly configured to form an internal environment of the battery cell 110 together with the end cover 11, where the formed internal environment may be configured to accommodate the electrode assembly 30, an electrolyte, and other components. The shell 20 and the end cover 11 may be separate components, an opening may be provided on the shell 20, and the end cover 11 covers the opening to form the internal environment of the battery cell 110. Without limitation, the end cover 11 and the shell 20 may alternatively be integrated. Specifically, the end cover 11 and the shell 20 may form a shared connection surface before other components are placed inside the housing, and then the end cover 11 covers the shell 20 when the inside of the shell 20 needs to be enclosed. The shell 20 may be of various shapes and sizes, such as a cuboid shape, a cylindrical shape, and a hexagonal prism shape. Specifically, a shape of the shell 20 may be determined according to a specific shape and size of the electrode assembly 30. The shell 20 may be made of various materials, such as copper, iron, aluminum, stainless steel, aluminum alloy, and plastic, which are not particularly limited in the embodiments of this application.

The electrode assembly 30 is a component in the battery cell 110 in which electrochemical reactions take place. The shell 20 may include one or more electrode assemblies 30. The electrode assembly 30 is mainly formed by winding or stacking a positive electrode plate and a negative electrode plate, with a separator typically disposed between the positive electrode plate and the negative electrode plate. Portions of the positive electrode plate and the negative electrode plate that have active substances constitute a body portion of the electrode assembly 30, while portions of the positive electrode plate and the negative electrode plate that have no active substance separately constitute a tab. A positive electrode tab and a negative electrode tab may both be located at one end of the body portion or be located at two ends of the body portion respectively. During charge and discharge of the battery 100, a positive electrode active substance and a negative electrode active substance react with an electrolyte, and the tabs are connected to the electrode terminals to form a current loop.

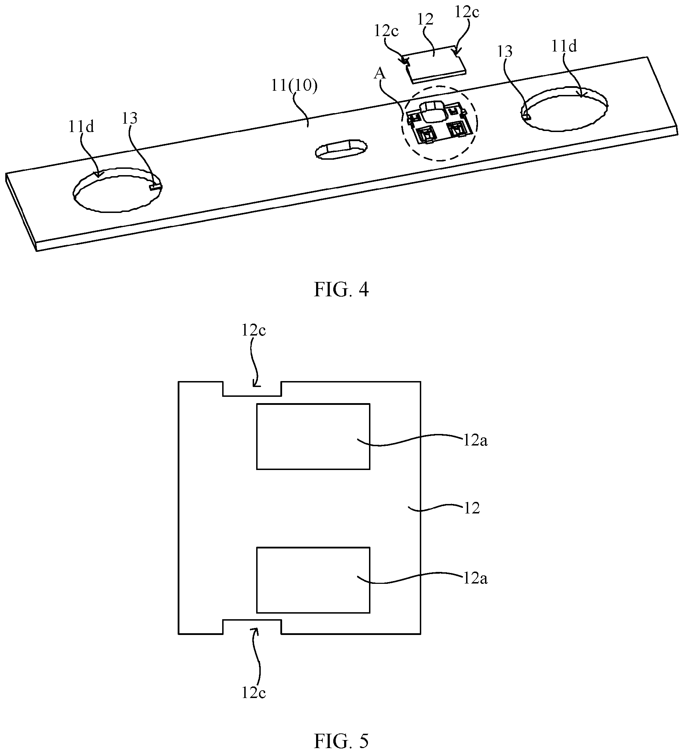

According to some embodiments of this application, refer to FIG. 3 and FIG. 4, this application provides a battery cell 110. The battery cell includes a housing 10, an electrode terminal 40, a conductor 13, and a sampling module 12. At least one conductor 13 is disposed on the housing 10 and electrically connected to the electrode terminal 40. The sampling module 12 is connected to the housing 10 and electrically connected to the conductor 13.

The sampling module 12 refers to a device for collecting status signals of the battery cell 110, that is, a device that can receive status signals from the battery cell 110 through the conductor 13 and has functions such as storing and processing the status signals, and the processed status signals are transmitted to BMU. The status signals refer to status information exhibited by the battery cell 110, for example, temperature signals, voltage signals, pressure signals from the battery cell 110. The sampling module 12 and the BMU communicate with each other in many ways. For example, the communication modes therebetween may be but are not limited to infrared communication, Bluetooth transmission, and ZigBee (ZigBee protocol).

The sampling module 12 may be designed as a PCB board, on which an integrated chip with a plurality of collection channels such as a voltage collection channel and a temperature collection channel can be arranged. The specific circuit structure of the sampling module 12 is not the object of improvement in this application. Therefore, for the specific circuit structure of the sampling module 12, reference may be directly made to existing products or literature, such as a collection module in CMC, and details are not specifically introduced herein.

The sampling module 12 can be mounted on the housing 10 in many ways. For example, the mounting methods may be, but are not limited to, welding, clamping, riveting, bolt connection, pin connection, and adhesive bonding.

The housing 10 refers to an external packaging structure of the battery cell 110. The housing 10 may be provided with the structure of the end cover 11, or may not be provided with the structure of the end cover 11, and in this case, the battery cell 110 is a cell structure without the end cover 11.

The conductor 13 refers to a structure that can transmit the status signals from the battery cell 110 to the sampling module 12 in the form of current or voltage. The conductor 13 may be provided in one or plurality. When the conductor 13 is provided in one, the conductor 13 is electrically connected to one electrode of the sampling module 12, and another electrode can be connected in other electrical connection ways, for example, directly welded to a collected component or electrically connected through other structures. When the conductor 13 is provided in two, when connected to the sampling module 12, one conductor 13 is connected to a positive electrode terminal of the sampling module 12, and the other conductor 13 is connected to a negative electrode terminal of the sampling module 12, forming a sampling circuit loop. The conductor 13 may be, but is not limited to, a wire, a conductive metal sheet (such as a copper sheet or an aluminum sheet).

The conductor 13 on the housing 10 may be directly arranged on a surface of the housing 10; or may be arranged inside the housing 10, that is, embedded inside the housing 10. When the conductor 13 is arranged on a surface of the housing 10, an outer surface of the conductor 13 needs to be insulated.

When the conductor 13 is provided in two, one of the two conductors 13 may be disposed on the housing 10 and electrically connected to the electrode terminal 40; the other conductor 13 may be connected to the electrode terminal 40, or may be not connected to the electrode terminal 40, for example, the conductor 13 is directly connected to a tab of the electrode assembly 30 in the battery cell 110, or the conductor 13 is connected to a connecting sheet in a pack assembly. When the two conductors 13 are both disposed on the housing 10 and are respectively electrically connected to the two electrode terminals 40, the signal transmission efficiency and path can both be effectively optimized, greatly reducing the influence of factors such as interference coupling and wiring harness short-circuiting, and improving the reliability of collection.

The sampling module 12 is integrated on the housing 10, and at least one conductor 13 is electrically connected to the electrode terminal 40, which changes the conventional method of transmitting signals to the CMC using a flexible circuit board and wiring harness, avoids the influence of factors such as interference coupling and wiring short-circuiting on the transmission of status signals, shortens the signal transmission path, and improves the reliability of signal collection by the sampling module 12. Moreover, during signal collection, there is no need to additionally configure the flexible circuit and wiring harness, which greatly reduces the cost of signal collection.

According to some embodiments of this application, optionally, referring to FIG. 4 and FIG. 5, the sampling module 12 has at least one conductive portion 12a, and when the sampling module 12 is connected to the housing 10, the conductive portion 12a is electrically connected to the corresponding conductor 13.

The conductive portion 12a refers to an electrical connection terminal on the sampling module 12, and is a component for inputting signals inward or outputting signals outward. The conductive portion 12a on the sampling module 12 may be designed as a socket structure or a plug structure, or may be designed as a pin or a gold finger structure. Specifically, in some embodiments, the conductive portion 12a is provided in two, and the two conductive portions 12a are electrically connected to the two conductors 13 in one-to-one correspondence.

With such a design, during assembly, the electrical conduction between the sampling module 12 and the conductor 13 can be achieved by simply connecting the conductive portion 12a to the conductor 13, which helps to improve assembly efficiency.

According to some embodiments of this application, optionally, referring to FIG. 4 to FIG. 6, the housing 10 is provided with a connecting member 15, where the connecting member 15 is electrically connected to the conductor 13. When the sampling module 12 is connected to the housing 10, the conductive portion 12a is electrically connected to the connecting member 15.

The connecting member 15 refers to a component that achieves electrical conduction between the conductor 13 and the conductive portion 12a. The connecting member 15 and the conductive portion 12a are connected in many ways. For example, the connection therebetween may be crimping, welding, plugging, bolt connection, or winding. Similarly, the connection between the connecting member 15 and the conductor 13 may alternatively be, but is not limited to, crimping, welding, plugging, bolt connection, or winding. Specifically, in some embodiments, the connecting member 15 is provided in two. The conductive portion 12a is electrically connected to the corresponding conductor 13 through the connecting member 15.

The housing 10 is provided with the corresponding connecting member 15, so that during assembly, the electrical conduction between the sampling module 12 and the conductor 13 can be implemented by simply connecting the conductive portion 12a to the connecting member 15, which helps to improve assembly efficiency.

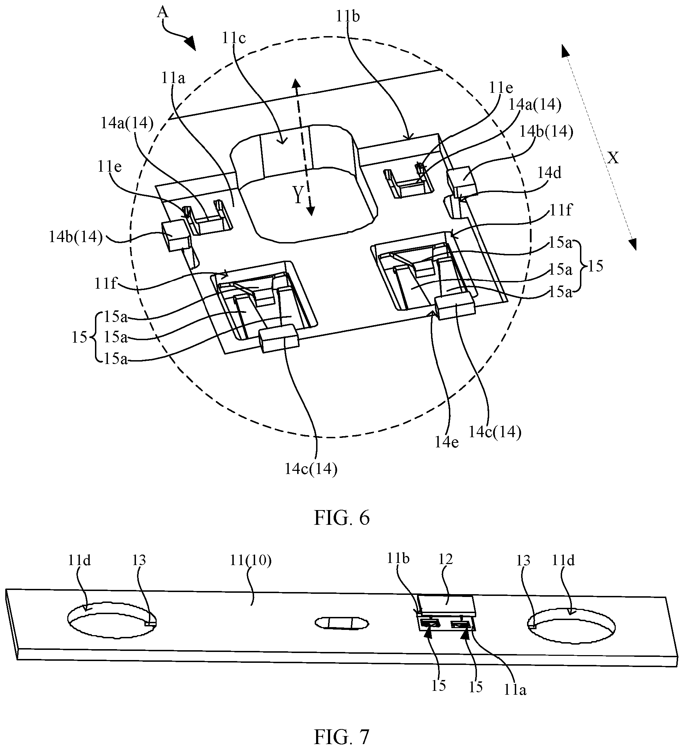

According to some embodiments of this application, optionally, referring to FIG. 6, the housing 10 has a mounting region 11a. The connecting member 15 is located in the mounting region 11a, and the sampling module 12 is mounted in the mounting region 11a.

The mounting region 11a is a region of a certain area on the housing 10, and this region may be a region directly on the surface of the housing 10, or the bottom of a recessed region on the housing 10.

The housing 10 is provided with the mounting region 11a, so that the mounting position of the sampling module 12 is defined, thereby maintaining the consistency of the position of the sampling module 12 in the battery cell 110.

According to some embodiments of this application, optionally, referring to FIG. 6, the battery cell 110 further includes a limiting structure 14 disposed on the housing 10, where the limiting structure 14 is constructed to limit the sampling module 12 within the mounting region 11a and to crimp the conductive portion 12a onto the connecting member 15 accordingly.

The limiting structure 14 refers to a component that can fix the sampling module 12 in the mounting region 11a and crimp the conductive portion 12a onto the connecting member 15 using a limiting force on the sampling module 12 to achieve electrical conduction. While fixing the sampling module 12, the limiting structure 14 can also allow the sampling module 12 to be entirely disassembled from the mounting region 11a. For example, at least part of the limiting structure 14 can rotate, move, or deform, causing at least one part of the sampling module 12 to lose its limiting function and enabling the sampling module 12 to release from the mounting region 11a.

The conductive portion 12a is crimped onto the connecting member 15, which should be understood as follows: When the sampling module 12 is limited within the mounting region 11a by the action of the limiting structure 14, the conductive portion 12a is in contact with the connecting member 15 and is tightly crimped onto the connecting member 15 under the limiting action of the limiting structure 14, enhancing the electrical connection strength therebetween and avoiding loosening that in turn leads to poor electrical contact.

With the limiting structure 14 provided, the sampling module 12 is stably fixed in the mounting region 11a, which helps to improve the reliability of signal collection; and in addition, the limiting structure 14 is used to directly crimp the conductive portion 12a onto the connecting member 15, which not only helps to improve the electrical connection strength but also facilitates the electrical connection between the conductive portion 12a and the connecting member 15, improving the assembly efficiency.

According to some embodiments of this application, optionally, the sampling module 12 is detachably mounted in the mounting region 11a.

The sampling module 12 is detachably mounted in the mounting region 11a in many ways. For example, a detachable component is provided within the mounting region 11a, and such component is used to connect the sampling module 12; or the electrical connection between the sampling module 12 and the connecting member 15 is designed to be detachable connection, for example, electrical plugging or electrical clamping.

The sampling module 12 is detachably mounted in the mounting region 11a, so that the sampling module 12 can be replaced, facilitating the maintenance of the battery cell 110.

According to some embodiments of this application, optionally, referring to FIG. 6, the limiting structure 14 includes a first limiting piece 14a. The first limiting piece 14a and the connecting member 15 are spaced apart within the mounting region 11a along a preset direction X, the preset direction X is perpendicular to the thickness direction Y of the housing 10 in the mounting region 11a, and the first limiting piece 14a limits one end of the sampling module 12 in the preset direction X.

It can be understood that the preset direction X may be any direction perpendicular to the thickness direction Y.

The first limiting piece 14a and the connecting member 15 are arranged along the preset direction X, so that when the sampling module 12 is plugged in the mounting region 11a along the preset direction X, the conductive portion 12a is crimped onto the connecting member 15 accordingly. In this case, the first limiting piece 14a abuts against one end of the sampling module 12 far away from the connecting member 15 in the preset direction X, so that the sampling module 12 can be prevented from moving along the preset direction X and in turn causing the conductive portion 12a to disengage from the connecting member 15.

In this way, the sampling module 12 is effectively limited in at least one direction, ensuring stable crimping of the conductive portion 12a and the connecting member 15, thereby improving the reliability of collection.

According to some embodiments of this application, optionally, referring to FIG. 6, the limiting structure 14 further includes a second limiting piece 14b. The second limiting piece 14b limits a side face of the sampling module 12 facing away from the mounting region 11a.

The second limiting piece 14b may be located inside the mounting region 11a or outside the mounting region 11a, provided that it limits the side face of the sampling module 12 facing away from the mounting region 11a. The second limiting piece 14b limits the side face of the sampling module 12 facing away from the mounting region 11a, which indicates that there is a certain gap between the second limiting piece 14b and the mounting region 11a. Such gap is formed in many ways. For example, the mounting region 11a is the bottom of a recessed region on the housing 10, so that a gap is formed between the second limiting piece 14b and the mounting region 11a; or the mounting region 11a is a surface of the housing 10, and the second limiting piece 14b is designed in an inverted L shape, so that a gap is formed between the second limiting piece 14b and the mounting region 11a.

The first limiting piece 14a and the second limiting piece 14b may be provided in one or plurality. When the first limiting piece 14a and the second limiting piece 14b are both provided in plurality, all the first limiting pieces 14a are spaced apart along a direction intersecting the preset direction X, and all of them abut against and limit one end of the sampling module 12 in the preset direction X; and all the second limiting pieces 14b may be spaced around the periphery of the mounting region 11a.

Optionally, the mounting method of the first limiting piece 14a inside the mounting region 11a may be bolt connection, clamping, riveting, adhesive bonding, welding, or integral molding. The integral molding may be injection molding, die casting, stamping, or the like. The mounting method of the second limiting piece 14b on the housing 10 may be, but is not limited to, bolt connection, clamping, riveting, adhesive bonding, welding, or integral molding.

With such a design, the first limiting piece 14a and the second limiting piece 14b are used, so that the sampling module 12 is effectively limited in at least two directions, which ensures stable crimping of the conductive portion 12a and the connecting member 15 and improves the reliability of collection.

According to some embodiments of this application, optionally, referring to FIG. 6, at least one of the first limiting piece 14a and the second limiting piece 14b is movable or deformable to allow the sampling module 12 to be limited or released within the mounting region 11a.

If the sampling module 12 needs to be limited in the mounting region 11a or released from the mounting region 11a, the first limiting piece 14a or the second limiting piece 14b can be moved or deformed, so that at least one limiting position is opened, allowing the sampling module 12 to be mounted into the mounting region 11a or removed from the mounting region 11a. The term "movement" means that the first limiting piece 14a or the second limiting piece 14b is designed to be movable, for example, rotating or sliding, so that the first limiting piece 14a is rotated or slid away from an initial position through moving. The term "deformation" means that the first limiting piece 14a or the second limiting piece 14b is subjected to structural deformation under external force, making space for the mounting or removal of the sampling module 12.

At least one of the first limiting piece 14a and the second limiting piece 14b is designed to be movable or deformable, so as to facilitate the mounting and removal of the sampling module 12.

According to some embodiments of this application, optionally, referring to FIG. 6, the mounting region 11a is provided with a first concave portion 11e. The first limiting piece 14a is disposed on an inner wall of the first concave portion 11e and at least partially protrudes from the first concave portion 11e. The first limiting piece 14a is constructed to be elastically pressed into the first concave portion 11e.

The first limiting piece 14a being constructed to be elastically pressed into the first concave portion 11e indicates that the first limiting piece 14a is an elastic structure. When the sampling module 12 is mounted in the mounting region 11a, the sampling module 12 can be used to squeeze the first limiting piece 14a into the first concave portion 11e; and then, the sampling module 12 is pushed along the preset direction X, so that the conductive portion 12a is crimped onto the connecting member 15. As the first limiting piece 14a at least partially protrudes from the first concave portion 11e in an initial state, when the sampling module 12 slides out of the first limiting piece 14a, the first limiting piece 14a is not subjected to pressure and springs up to its initial state to abut against and limit one end of the sampling module 12 in the preset direction X. It should be noted that the mounting method of the sampling module 12 shown above is only for the purpose of explaining the design concept of the first limiting piece 14a and should not be interpreted as a limitation on the mounting method of the sampling module 12 in this application. The sampling module 12 of this application can be mounted in the mounting region 11a in many ways, provided that it can be stably limited in the mounting region 11a by the limiting structure 14.

The material of the first limiting piece 14a is not specifically limited, provided that the first limiting piece 14a can elastically deform within the first concave portion 11e. The first concave portion 11e may be provided in one or plurality. When the first concave portion 11e is provided in plurality, the plurality of first concave portions 11e are spaced apart along a direction intersecting the preset direction X.

In addition, a relationship between the number of first concave portions 11e and the number of first limiting pieces 14a may be one-to-one or may be many-to-one. For example, the plurality of first limiting pieces 14a can be arranged on the inner wall of the same first concave portion 11e.

The first limiting piece 14a is designed to be elastically pressed into the first concave portion 11e, so that the sampling module 12 can be more conveniently mounted into the mounting region 11a, improving assembly efficiency. Moreover, the first limiting piece 14a at least partially protrudes from the first concave portion 11e, so that the sampling module 12 mounted in the mounting region 11a can abut against the first limiting piece 14a, ensuring stable fixation of the sampling module 12.

According to some embodiments of this application, optionally, referring to FIG. 6, in the thickness direction Y of the housing 10 in the mounting region 11a, there is a mounting gap 14d between the second limiting piece 14b and the mounting region 11a. The mounting gap 14d is constructed to allow the sampling module 12 squeezing the first limiting piece 14a to move along the preset direction X, and when the sampling module 12 moves to a point where the conductive portion 12a is crimped onto the connecting member 15, the first limiting piece 14a springs up and limits one end of the sampling module 12.

The mounting gap 14d is enough for the sampling module 12 squeezing the first limiting piece 14a to move along the preset direction X, but the mounting gap 14d should not be too large, otherwise the second limiting piece 14b is not able to abut against and limit the side face of the sampling module 12 facing away from the mounting region 11a.

When the conductive portion 12a is crimped onto the connecting member 15, the first limiting piece 14a springs up, meaning that after the sampling module 12 moves to a certain position along the preset direction X, the sampling module 12 is out of contact with the first limiting piece 14a, so that the first limiting piece 14a loses its squeezing action, and springs up and protrudes from the first concave portion 11e under its own elasticity to abut against and limit one end of the sampling module 12 in the preset direction X.

To ensure that the first limiting piece 14a springs up when the sampling module 12 moves within the mounting region 11a, the mounting region 11a should have sufficient moving space along the preset direction X. For example, a distance between one end of the mounting region 11a close to the connecting member 15 and the first limiting piece 14a should be equal to or slightly greater than a length of the sampling module 12 along the preset direction X.

The mounting gap 14d is provided between the second limiting piece 14b and the mounting region 11a, so that during the mounting of the sampling module 12, limitation and electrical connection of the sampling module 12 can be implemented by simply moving along the preset direction X in the mounting gap 14d, making the mounting of the sampling module 12 more convenient.

According to some embodiments of this application, optionally, referring to FIG. 5 and FIG. 6, the sampling module 12 is provided with a notch 12c, where the notch 12c is configured for the sampling module 12 to pass through the second limiting piece 14b.

As the second limiting piece 14b abuts against and limits the side face of the sampling module 12 facing away from the mounting region 11a, before the sampling module 12 is placed into the mounting region 11a, it is interfered by the second limiting piece 14b, resulting in the sampling module 12 being unable to be placed into the mounting region 11a. To solve this, the notch 12c is provided on the sampling module 12, and the sampling module 12 passes through the second limiting piece 14b via the notch 12c, so that the sampling module 12 is placed into the mounting region 11a and squeezes the first limiting piece 14a. In this case, the first limiting piece 14a is squeezed into the first concave portion 11e; and in turn pushes the sampling module 12 along the preset direction X, so that the conductive portion 12a is crimped onto the connecting member 15. Meanwhile, the sampling module 12 slides out of the first limiting piece 14a, so that the first limiting piece 14a at least partially springs up and abuts against one end of the sampling module 12 to limit the sampling module 12 in the mounting region 11a.

The size of the notch 12c is not limited, provided that the notch 12c allows the second limiting piece 14b to pass through. Moreover, the shape of the notch 12c can be designed as, but is not limited to, square, semi-circular, or semi-elliptical.

The notch 12c is used to avoid the interference from the second limiting piece 14b to ensure that the sampling module 12 is smoothly placed into the mounting region 11a, so that the sampling module 12 can be better assembled.

According to some embodiments of this application, optionally, referring to FIG. 6, the connecting member 15 includes a connecting piece 15a electrically connected to the conductor 13, the mounting region 11a is provided with a second concave portion 11f spaced apart from the first concave portion 11e along the preset direction X, and the connecting piece 15a is elastically disposed on an inner wall of the second concave portion 11f and at least partially protrudes from the second concave portion 11f.

The first concave portion 11e and the second concave portion 11f are spaced apart along the preset direction X, which can ensure that when the sampling module 12 moves along the preset direction X, the conductive portion 12a is electrically connected to the connecting piece 15a, and the sampling module 12 slides away from the first limiting piece 14a, causing the first limiting piece 14a to spring up and abut against one end of the sampling module 12.

The connecting piece 15a at least partially protrudes from the second concave portion 11f, which ensures stable contact between the conductive portion 12a and the connecting piece 15a, thereby maintaining good contact between the sampling module 12 and the connecting member 15. To avoid rigid contact, the connecting piece 15a is elastically disposed on the inner wall of the second concave portion 11f, so that the connecting piece 15a elastically deforms within the second concave portion 11f.

The material of the connecting piece 15a is not specifically limited, provided that the connecting piece 15a can elastically deform within the second concave portion 11f. The second concave portion 11f may be provided in one or plurality. When the second concave portion 11f is provided in plurality, the plurality of second concave portions 11f are spaced apart along a direction intersecting the preset direction X.

The connecting piece 15a is elastically disposed on the inner wall of the second concave portion 11f and at least partially protrudes from the second concave portion 11f, which can not only ensure stable contact between the connecting piece 15a and the conductive portion 12a, but also avoid structural damage caused by rigid contact therebetween.

According to some embodiments of this application, optionally, referring to FIG. 6, in the same connecting member 15, the connecting piece 15a is provided in at least two, and all the connecting pieces 15a are spaced apart on the inner wall of the second concave portion 11f and electrically connected to the same conductor 13.

All the connecting pieces 15a are arranged in the second concave portion 11f in many ways. For example, all the connecting pieces 15a can be arranged in a row in the second concave portion 11f; or all the connecting pieces 15a can be spaced around the circumference of the second concave portion 11f.

The plurality of connecting pieces 15a are arranged in the second concave portion 11f, so that the number of contact points between the connecting member 15 and the conductive portion 12a are increased, which helps to ensure stable electrical conduction therebetween.

According to some embodiments of this application, optionally, referring to FIG. 6, the limiting structure 14 further includes a third limiting piece 14c, where the third limiting piece 14c is located at an end of the mounting region 11a close to the connecting member 15, and a limiting gap 14e is left between the third limiting piece 14c and the mounting region 11a.

The third limiting piece 14c may be provided in one or plurality. When the third limiting piece 14c is provided in plurality, the plurality of third limiting pieces 14c can be spaced around the periphery of the mounting region 11a.

Optionally, the mounting method of the third limiting piece 14c inside the mounting region 11a may be bolt connection, clamping, riveting, adhesive bonding, welding, or integral molding. The integral molding may be injection molding, die casting, stamping, or the like.

As the limiting gap 14e is left between the third limiting piece 14c and the mounting region 11a, when the sampling module 12 moves along the preset direction X, one end of the sampling module 12 is plugged in the limiting gap 14e, which avoids the upwarping of one end of the sampling module 12 caused by contact between the conductive portion 12a and the connecting member 15, and ensures the stable fixation of the sampling module 12 in the mounting region 11a.

According to some embodiments of this application, optionally, referring to FIG. 7, the connecting member 15 is electrically plugged in the corresponding conductive portion 12a.

The connecting member 15 is plugged in the conductive portion 12a in many ways. For example, the connecting member 15 is designed as a structure with a socket, and the conductive portion 12a is designed as a plug structure; or the connecting member 15 is designed as a plug structure, and the conductive portion 12a is designed as a structure with a socket.

The connecting member 15 is electrically plugged in the conductive portion 12a, which not only ensures stable electrical connection between the connecting member 15 and the conductive portion 12a, but also implements detachable connection between the sampling module 12 and the mounting region 11a through their electrical plugging, facilitating assembly and maintenance.

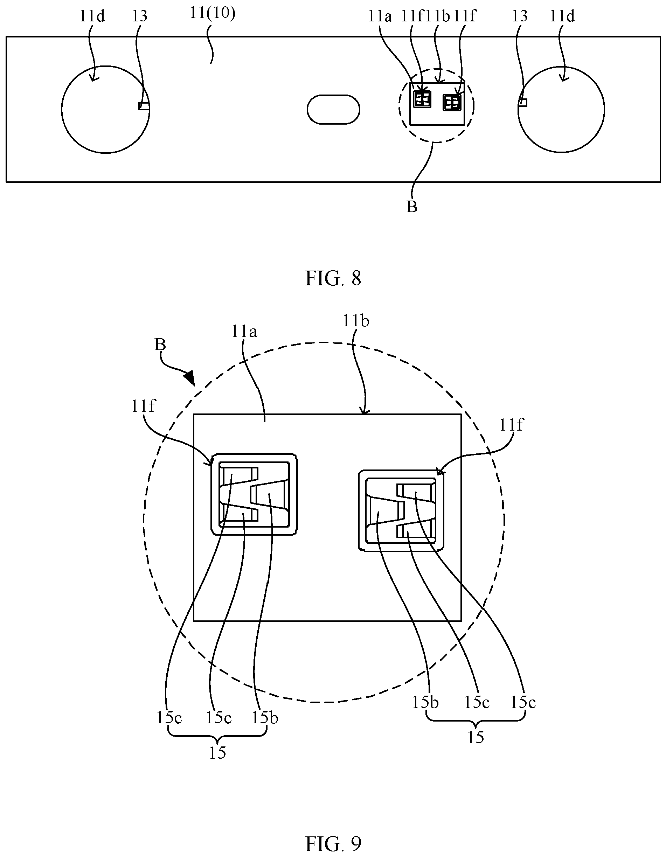

According to some embodiments of this application, optionally, referring to FIG. 8 to FIG. 14, the conductive portion 12a includes a plug-in protrusion 12b protruding from the surface of the sampling module 12. The plug-in protrusion 12b is plug-fitted with the connecting member 15.

The plug-in protrusion 12b refers to a component protruding from the surface of the sampling module 12, and can be plugged into the connecting member 15. In this case, the connecting member 15 has a space for the plug-in protrusion 12 to be plugged in.

In this way, the plugging method is used, so that the sampling module 12 is quickly electrically connected to the connecting member 15, improving assembly efficiency.

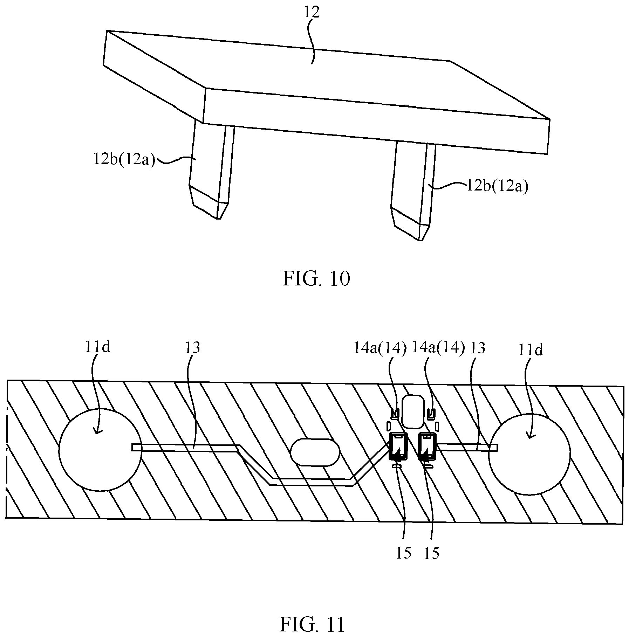

According to some embodiments of this application, optionally, referring to FIG. 9 and FIG. 10, the connecting member 15 includes a first clamping piece 15b and second clamping piece 15c disposed in the mounting region 11a. The plug-in protrusion 12b is plugged in between the first clamping piece 15b and the second clamping piece 15c.

The plug-in protrusion 12b is plugged in between the first clamping piece 15b and the second clamping piece 15c, which should be understood as follows: When the plug-in protrusion 12b is plugged in between the first clamping piece 15b and the second clamping piece 15c, the structures remain interconnected under the clamping action between the first clamping piece 15b and the second clamping piece 15c. To ensure that the plug-in protrusion 12b is stably plugged in the connecting member 15, the gap between the first clamping piece 15b and the second clamping piece 15c can be reduced; or the second clamping piece 15c can be designed as two, with free ends of the two second clamping pieces 15c located on two sides of the free end of the first clamping piece 15b.

In addition, to ensure that the plug-in protrusion 12b can be plugged to a certain depth, the mounting region 11a can be provided with a second concave portion 11f, where the first clamping piece 15b and the second clamping piece 15c are respectively disposed on opposite inner walls of the second concave portion 11f. Moreover, when the first clamping piece 15b and the second clamping piece 15c are respectively designed as elastic pieces, the plug-in protrusion 12b can be stably clamped by the elastic force, thereby improving the stability of the plugging between the plug-in protrusion 12b and the connecting member 15.

The connecting member 15 is designed as the first clamping piece 15b and the second clamping piece 15c, so that the conductive portion 12a can be stably plugged in the connecting member 15, which ensures good electrical contact and helps to improve the reliability of signal collection.

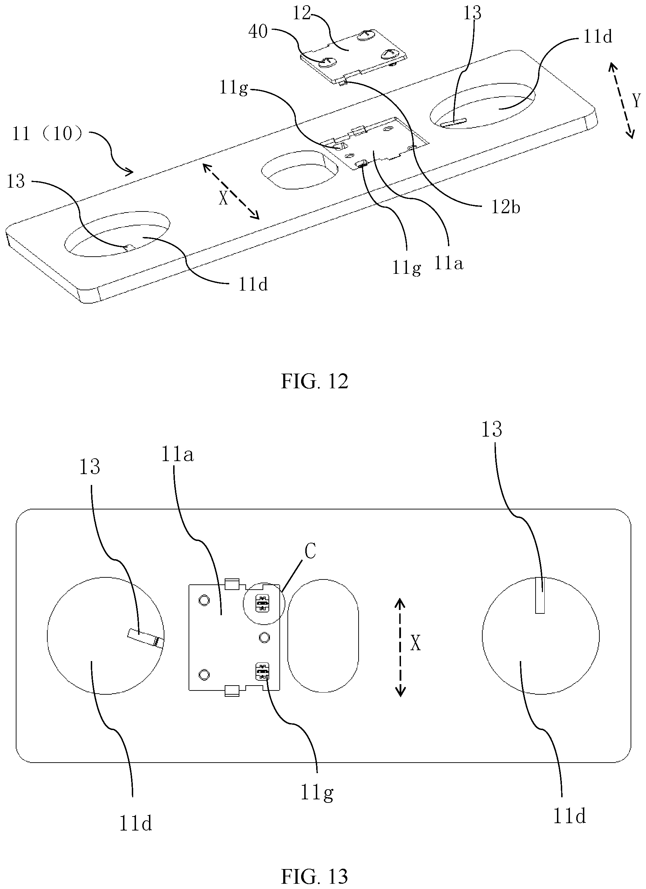

According to some embodiments of this application, optionally, referring to FIG. 12 to FIG. 15, the connecting member 15 includes a conductive elastic piece 15d disposed in the mounting region 11a, a plug-in hole 11g extending along the thickness direction Y of the housing 10 in the mounting region 11a is formed in the mounting region 11a, the plug-in protrusion 12b is plug-fitted with the plug-in hole 11g, the conductive elastic piece 15d is disposed on a side wall of the plug-in hole 11g and abuts against the plug-in protrusion 12b under the elastic force of the conductive elastic piece 15d, and the conductor 13 is electrically connected to the plug-in protrusion 12b through the conductive elastic piece 15d.

The conductive elastic piece 15d may be a conductive metal elastic piece, or may be a non-metallic elastic piece with a conductive coating on a surface, specifically, it may be an elastic sheet structure.

The shape of the plug-in hole 11g can be specifically set according to the shape of the plug-in protrusion 12b, for example, may be square, circle, or oval, and is not specifically limited herein.

The plug-in hole 11g can be a through hole extending along the thickness direction Y of the housing 10 in the mounting region 11a, or may be a non-through hole, and is not specifically limited herein.

Optionally, the number of conductive elastic pieces 15d in the plug-in hole 11g may be one or more.

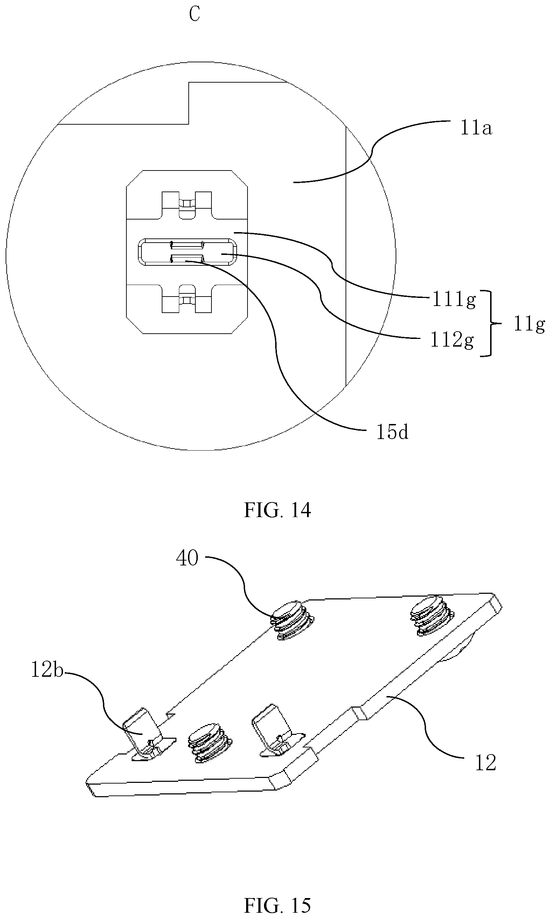

For example, referring to FIG. 14 and FIG. 15, the plug-in hole 11g includes a first plug-in hole 11g and a second plug-in hole 11g, where the second plug-in hole 11g is formed at the bottom of the first plug-in hole 11g, the conductive elastic piece 15d is disposed on a side wall of the second plug-in hole 11g, a boss is formed at a position where the plug-in protrusion 12b is connected to the sampling module 12, the first plug-in hole 11g can accommodate the boss, and after the plug-in protrusion 12b is plugged in the second plug-in hole 11g and the plug-in protrusion 12b abuts against the conductive elastic piece 15d, the boss is located in the first plug-in hole 11g, which avoids structural interference between the sampling module 12 and the plug-in hole 11g, so that an outer surface of the sampling module 12 does not protrude from the outer surface of the housing 10, so as to improve the space utilization of the battery cell 110.

For example, the plug-in hole 11g may alternatively be a straight hole (the cross-section of the axis of the through hole has no step), the surface of the sampling module 12 facing the mounting region 11a is flat, and the plug-in protrusion 12b of the sampling module can be directly plug-fitted with the plug-in hole 11g.

The plug-in protrusion 12b is plug-fitted with the plug-in hole 11g, and under the elastic force of the conductive elastic piece 15d, the plug-in protrusion 12b always maintains electrical connection with the conductive elastic piece 15d, which has good electrical contact, so as to improve the reliability of signal collection by the sampling module 12.

In some embodiments, referring to FIG. 12 to FIG. 15, the battery cell 110 further includes a fastener 50, the sampling module 12 is provided with a through hole extending along the thickness direction of the housing 10, and the fastener 50 passes through the through hole to be connected to the mounting region 11a of the housing 10.

The fastener 50 may be a screw, may be a combination of a screw and a nut, or may be a combination of a screw, a nut, and a gasket.

For example, the mounting region 11a is provided with a threaded hole, and the fastener 50 passes through the through hole and is threadedly connected to the threaded hole of the mounting region 11a. In other connection methods, the threaded hole may be replaced with a through hole, and the fixed connection between the sampling module and the housing 10 can be achieved through the connection of a nut and a screw.

The sampling module 12 and the housing 10 can be disassembled and assembled through the fastener 50, which provides a simple structure and makes assembly and disassembly convenient.

In some embodiments, referring to FIG. 1 and FIG. 12 to FIG. 14, the electrode terminals 40, the plug-in protrusions 12b, the conductors 13, and the plug-in holes 11g are all provided in two, where the two plug-in protrusions 12b and the two plug-in holes 11g are both spaced apart along the preset direction X, the preset direction X is perpendicular to the thickness direction of the housing 10 in the mounting region 11a, one electrode terminal 40 is electrically connected to one conductive elastic piece 15d through one conductor 13, one conductive elastic piece 15d is electrically connected to one plug-in protrusion 12b, the other electrode terminal 40 is electrically connected to the other conductive elastic piece 15d through the other conductor 13, and the other conductive elastic piece 15d is electrically connected to the other plug-in protrusion 12b.

It should be noted that one of the two electrode terminals 40 may be a positive electrode terminal and the other may be a negative electrode terminal, and the two are electrically connected to the conductive elastic pieces 15d in the two plug-in holes 11g in one-to-one correspondence through different conductors 13, and the conductive elastic pieces 15d in the two plug-in holes 11g are electrically connected to the two plug-in protrusions 12b in one-to-one correspondence.

In this way, the electrical connection between the two electrode terminals 40 of the battery cell 110 and the two plug-in protrusions 12b of the sampling module 12 can be achieved, and the reliability of the electrical connection between the electrode terminals 40 and the sampling module 12 can be improved through the arrangement of the conductive elastic pieces 15d.

In some embodiments, referring to FIG. 14, the number of conductive elastic pieces 15d in the plug-in hole 11g is two, and the two conductive elastic pieces 15d are located on opposite sides of the plug-in protrusion 12b.

The two conductive elastic pieces 15d in the plug-in hole 11g may be directly opposite or may be diagonally opposite, and are not specifically limited herein.

In this way, the two conductive elastic pieces 15d located on opposite sides of the plug-in protrusion 12b can clamp the plug-in protrusion 12b under the elastic force of the conductive elastic pieces 15d, which further improves the reliability of the electrical connection between the conductive elastic pieces 15d and the plug-in protrusion 12b.

According to some embodiments of this application, optionally, referring to FIG. 8, the housing 10 is provided with a mounting groove 11b. The mounting region 11a is a bottom wall of the mounting groove 11b.

The mounting groove 11b refers to a structure recessed in the thickness direction of the housing 10 on the surface of the housing 10, and its recessed depth may be determined depending on a thickness of the sampling module 12. Moreover, the shape of the mounting groove 11b may be designed in many ways. For example, the mounting groove 11b may be designed in a square, round, oval, pentagonal shape.

To facilitate the removal of the sampling module 12 from the mounting region 11a or to avoid structural interference with the sampling module 12, the mounting region 11a can be provided with a groove 11c.

The mounting region 11a is constructed as the bottom wall of the mounting groove 11b, so that the mounting region 11a has a certain height difference from the surface of the housing 10, which makes the mounting of the sampling module 12 more stable, and also avoids the sampling module 12 protruding from the surface of the housing 10, leading to the ineffective utilization of the space in a height direction of the battery cell 110.

According to some embodiments of this application, optionally, the housing 10 includes a shell 20 and an end cover 11 covering the shell 20, where the sampling module 12, the electrode terminal 40, and the conductor 13 are all connected to the end cover 11.

The shell 20 refers to a structure that can accommodate the electrode assembly 30. The end cover 11 refers to a component that covers the shell 20, so that the shell 20 has a closed cavity inside.

The sampling module 12 and the conductor 13 are both arranged on the end cover 11, so that the conductor 13 is more easily electrically connected to the electrode terminal 40 on the end cover 11, which shortens the transmission path of the electrical signal, and helps to improve the reliability of signal collection by the sampling module 12.

According to some embodiments of this application, optionally, referring to FIG. 8, the end cover 11 is provided with a through hole 11d extending along a thickness direction of the end cover 11. The through hole 11d is configured for the mounting of the electrode terminal 40, and one end of the conductor 13 disposed on the end cover 11 extends into the through hole 11d.

One end of the conductor 13 extends into the through hole 11d for the purpose that when the electrode terminal 40 is mounted in the through hole 11d, one end of the conductor 13 is in contact with the electrode terminal 40, so as to achieve electrical communication between the conductor 13 and the electrode terminal 40. As for the amount of extension of the conductor 13 into the through hole 11d, it should not be too little, nor too much. Too much will occupy too much space in the through hole 11d, resulting in the electrode terminal 40 unable to be mounted in the through hole 11d.

One end of the conductor 13 extends into the through hole 11d, which makes the electrical connection between the electrode terminal 40 and the conductor 13 more convenient, and helps to improve the assembly efficiency of the battery cell 110.

According to some embodiments of this application, optionally, referring to FIG. 11, the conductor 13 is embedded in the end cover 11, and one end of the conductor 13 extends in and passes through a wall of the through hole 11d.

The conductor 13 is embedded in the end cover 11, which can be understood as follows: Most of the structure of the conductor 13 is embedded in the end cover 11. The conductor 13 is embedded in the end cover 11 in many ways, for example, by injection molding the conductor 13 into the end cover 11; or by opening a hole in the end cover 11 and threading the conductor 13 through the hole. When the material of the end cover 11 is an insulating material, or example, rubber or plastic, the conductor 13 embedded in the end cover 11 does not need to be insulated with an insulating sheath.

In addition, the part of the conductor 13 that extends through the wall of the through hole 11d may be, but is not limited to, a nickel sheet, which is welded to the electrode terminal 40 in the through hole 11d during connection.

The conductor 13 is embedded in the end cover 11, so that the conductor 13 is avoided from being directly exposed on the surface of the end cover 11, which easily causes structural interference inside the battery cell 110; and moreover, the insulation of the outer surface of the conductor 13 can also be implemented by embedding the conductor 13 in the end cover 11.

According to some embodiments of this application, optionally, referring to FIG. 11, the numbers of through holes 11d and conductors 13 are both two, the two conductors 13 are disposed on the end cover 11, and one ends of the two conductors 13 respectively extend into the two through holes 11d.

The extension of one end of each conductor 13 into the corresponding through hole 11d means that the signals collected by the sampling module 12 are transmitted by the two electrode terminals 40, greatly improving the reliability of signal collection. Moreover, the two conductors 13 are both disposed on the end cover 11 and are respectively connected to the two electrode terminals 40, which makes the signal collection circuit layout of the battery cell 110 more concise and reasonable.

When the two conductors 13 are disposed on the end cover 11, the conductors 13 may be directly arranged on the surface of the end cover 11, or may be arranged inside the end cover 11.

One ends of the conductors 13 extend into the corresponding through holes 11d respectively, so that the conductors 13 can be electrically connected to the electrode terminals 40 and transmit status signals through the electrode terminals 40, which further improves the reliability of signal collection.

According to some embodiments of this application, this application provides a battery 100, including the foregoing battery cell 110.

According to some embodiments of this application, this application provides an electric apparatus, including the foregoing battery 100, where the battery 100 is configured to provide electric energy.

According to some embodiments of this application, referring to FIG. 4 to FIG. 11, this application provides an intelligent cell sampling structure-gold finger solution, where a conductor 13 and a connecting member 15 are injection molded on an end cover 11, and a sampling module 12 is provided with a corresponding conductive portion 12a. Two conductors 13 are respectively connected to corresponding electrode terminals 40, electrical signals are transmitted to the connecting member 15 (for example, an elastic piece) through the conductors 13, and then voltage sampling is implemented through contact between the connecting member 15 and the conductive portion 12a.

In addition, the mounting method of the sampling module 12 on the end cover 11 may be a snap-fit and direct plugging method. The snap-fit method is that: the sampling module 12 is plugged in the end cover 11 along the preset direction X, the sampling module 12 is fixed using second limiting pieces 14b on two sides, and after the sampling module 12 is plugged in place, the first limiting piece 14a (such as an elastic piece snap-fit) at the tail end is uplifted to fix the sampling module 12. The direct plugging method is that: the conductive portion 12a is designed as a plug-in protrusion 12b, and the plug-in protrusion 12b is directly plugged into the connecting member 15.

In conclusion, it should be noted that the foregoing embodiments are for description of the technical solutions of this application only rather than for limiting this application. Although this application has been described in detail with reference to the foregoing embodiments, persons of ordinary skill in the art should appreciate that they can still make modifications to the technical solutions described in the embodiments or make equivalent replacements to some or all technical features thereof without departing from the scope of the technical solutions of the embodiments of this application. All such modifications and equivalent replacements shall fall within the scope of claims and specification of this application. In particular, as long as there is no structural conflict, the various technical features mentioned in the embodiments can be combined in any manner. This application is not limited to the specific embodiments disclosed in this specification but includes all technical solutions falling within the scope of the claims.

## Claims

1. A battery cell (110), **characterized by** comprising:
a housing (10);
an electrode terminal (40);
at least one conductor (13), disposed on the housing (10) and electrically connected to the electrode terminal (40); and
a sampling module (12), connected to the housing (10) and electrically connected to the conductor (13).

2. The battery cell (110) according to claim 1, **characterized in that** the sampling module (12) has at least one conductive portion (12a), and when the sampling module (12) is connected to the housing (10), the conductive portion (12a) is electrically connected to the conductor (13).

3. The battery cell (110) according to claim 2, **characterized in that** the housing (10) is provided with a connecting member (15), the connecting member (15) is electrically connected to the conductor (13), and when the sampling module (12) is connected to the housing (10), the conductive portion (12a) is electrically connected to the connecting member (15).

4. The battery cell (110) according to claim 3, **characterized in that** the housing (10) has a mounting region (11a), the connecting member (15) is located in the mounting region (11a), and the sampling module (12) is mounted in the mounting region (11a).

5. The battery cell (110) according to claim 4, **characterized in that** the sampling module (12) is detachably mounted in the mounting region (11a).

6. The battery cell (110) according to claim 4 or 5, **characterized in that** the battery cell (110) further comprises a limiting structure (14) disposed on the housing (10), wherein the limiting structure (14) is constructed to limit the sampling module (12) within the mounting region (11a) and to crimp the conductive portion (12a) onto the connecting member (15) accordingly.

7. The battery cell (110) according to claim 6, **characterized in that** the limiting structure (14) comprises a first limiting piece (14a), wherein the first limiting piece (14a) and the connecting member (15) are spaced apart within the mounting region (11a) along a preset direction (X), the preset direction (X) being perpendicular to a thickness direction (Y) of the housing (10) in the mounting region (11a), and the first limiting piece (14a) limits one end of the sampling module (12) in the preset direction (X).

8. The battery cell (110) according to claim 7, **characterized in that** the limiting structure (14) further comprises a second limiting piece (14b), wherein the second limiting piece (14b) limits a side face of the sampling module (12) facing away from the mounting region (11a).

9. The battery cell (110) according to claim 8, **characterized in that** at least one of the first limiting piece (14a) and the second limiting piece (14b) is movable or deformable to allow the sampling module (12) to be limited or released within the mounting region (11a).

10. The battery cell (110) according to claim 9, **characterized in that** the mounting region (11a) is provided with a first concave portion (11e), wherein the first limiting piece (14a) is disposed on an inner wall of the first concave portion (11e) and at least partially protrudes from the first concave portion (11e), and the first limiting piece (14a) is constructed to be elastically pressed into the first concave portion (11e).

11. The battery cell (110) according to claim 10, **characterized in that** in the thickness direction (Y) of the housing (10) in the mounting region (11a), there is a mounting gap (14d) between the second limiting piece (14b) and the mounting region (11a), the mounting gap (14d) being constructed to allow the sampling module (12) squeezing the first limiting piece (14a) to move along the preset direction (X), and when the sampling module (12) moves to a point where the conductive portion (12a) is crimped onto the connecting member (15), the first limiting piece (14a) springs up and limits one end of the sampling module (12).

12. The battery cell (110) according to claim 11, **characterized in that** the sampling module (12) is provided with a notch (12c), wherein the notch (12c) is configured for the sampling module (12) to pass through the second limiting piece (14b).

13. The battery cell (110) according to any one of claims 10 to 12, **characterized in that** the connecting member (15) comprises a connecting piece (15a) electrically connected to the conductor (13), the mounting region (11a) is provided with a second concave portion (11f) spaced apart from the first concave portion (11e) along the preset direction (X), and the connecting piece (15a) is elastically disposed on the inner wall of the second concave portion (11f) and at least partially protrudes from the second concave portion (11f).

14. The battery cell (110) according to claim 13, **characterized in that** in the same connecting member (15), the connecting piece (15a) is provided in at least two, and all the connecting pieces (15a) are spaced apart on an inner wall of the second concave portion (11f) and electrically connected to the same conductor (13).

15. The battery cell (110) according to any one of claims 6 to 14, **characterized in that** the limiting structure (14) further comprises a third limiting piece (14c), wherein the third limiting piece (14c) is located at an end of the mounting region (11a) close to the connecting member (15), and a limiting gap (14e) is left between the third limiting piece (14c) and the mounting region (11a).

16. The battery cell (110) according to claim 4 or 5, **characterized in that** the connecting member (15) is electrically plugged in the conductive portion (12a).

17. The battery cell (110) according to claim 16, **characterized in that** the conductive portion (12a) comprises a plug-in protrusion (12b) protruding from a surface of the sampling module (12), wherein the plug-in protrusion (12b) is plug-fitted with the connecting member (15).

18. The battery cell (110) according to claim 17, **characterized in that** the connecting member (15) comprises a first clamping piece (15b) and second clamping piece (15c) disposed in the mounting region (11a), wherein the plug-in protrusion (12b) is inserted between the first clamping piece (15b) and the second clamping piece (15c).

19. The battery cell (110) according to claim 17, **characterized in that** the connecting member (15) comprises a conductive elastic piece (15d) disposed in the mounting region (11a), a plug-in hole (11g) extending along the thickness direction (Y) of the housing (10) in the mounting region (11a) is formed in the mounting region (11a), the plug-in protrusion (12b) is plug-fitted with the plug-in hole (11g), the conductive elastic piece (15d) is disposed on a side wall of the plug-in hole (11g) and abuts against the plug-in protrusion (12b) under the elastic force of the conductive elastic piece (15d), and the conductor (13) is electrically connected to the plug-in protrusion (12b) through the conductive elastic piece (15d).

20. The battery cell (110) according to any one of claims 4 to 19, **characterized in that** the battery cell (110) further comprises a fastener (50), the sampling module (12) is provided with a through hole extending along the thickness direction (Y) of the housing (10), and the fastener (50) passes through the through hole to be connected to the mounting region (11a) of the housing (10).

21. The battery cell (110) according to claim 19 or 20, **characterized in that** the electrode terminal (40), the plug-in protrusion (12b), the conductor (13), and the plug-in hole (11g) are all provided in two, wherein the two plug-in protrusions (12b) and the two plug-in holes (11g) are both spaced apart along the preset direction (X), the preset direction (X) is perpendicular to the thickness direction (Y) of the housing (10) in the mounting region (11a), one electrode terminal (40) is electrically connected to one conductive elastic piece (15d) through one conductor (13), one conductive elastic piece (15d) is electrically connected to one plug-in protrusion (12b), the other electrode terminal (40) is electrically connected to the other conductive elastic piece (15d) through the other conductor (13), and the other conductive elastic piece (15d) is electrically connected to the other plug-in protrusion (12b).

22. The battery cell (110) according to claim 20 or 21, **characterized in that** the number of conductive elastic pieces (15d) in the plug-in hole (11g) is two, and the two conductive elastic pieces (15d) are located on opposite sides of the plug-in protrusion (12b).

23. The battery cell (110) according to any one of claims 4 to 22, **characterized in that** the housing (10) is provided with a mounting groove (11b), wherein the mounting region (11a) is a bottom wall of the mounting groove (11b).

24. The battery cell (110) according to any one of claims 1 to 23, **characterized in that** the housing (10) comprises a shell (20) and an end cover (11) covering the shell (20), wherein the sampling module (12), the electrode terminal (40), and the conductor (13) are all connected to the end cover (11).

25. The battery cell (110) according to claim 24, **characterized in that** the end cover (11) is provided with a through hole (11d) extending along a thickness direction of the end cover (11), wherein the through hole (11d) is used for mounting of the electrode terminal (40), and one end of the conductor (13) disposed on the end cover (11) extends into the through hole (11d).

26. The battery cell (110) according to claim 25, **characterized in that** the conductor (13) is embedded in the end cover (11), and one end of the conductor (13) extends and passes through a wall of the through hole (11d).

27. The battery cell (110) according to claim 25 or 26, **characterized in that** the through hole (11d) and the conductor (13) are both provided in two, the two conductors (13) are disposed on the end cover (11), and one ends of the two conductors (13) respectively extends into the two through holes (11d).

28. A battery (100), **characterized by** comprising the battery cell (110) according to any one of claims 1 to 27.

29. An electric apparatus, **characterized by** comprising the battery (100) according to any one of claim 28, wherein the battery (100) is configured to supply electric energy.
